Europäisches Patentamt

European Patent Office

Office européen des brevets

(11) Publication number: **0 054 035**
**B1**

(12) **EUROPEAN PATENT SPECIFICATION**

(45) Date of publication of patent specification: **18.09.85**

(21) Application number: **81901383.0**

(22) Date of filing: **18.06.80**

(86) International application number:
**PCT/US80/00753**

(87) International publication number:
**WO 81/03725 24.12.81 Gazette 81/30**

(51) Int. Cl.⁴: **H 03 M 3/04**

(54) **INTERPOLATIVE ANALOG-TO-DIGITAL CONVERTER.**

(43) Date of publication of application:
**23.06.82 Bulletin 82/25**

(45) Publication of the grant of the patent:
**18.09.85 Bulletin 85/38**

(84) Designated Contracting States:
**DE GB NL SE**

(56) References cited:
**US-A-3 550 004**
**US-A-3 587 087**
**US-A-3 820 111**
**US-A-3 956 700**

**IEEE JOURNAL OF SOLID-STATE CIRCUITS,
vol. SC-14, no. 1, February 1979 NEW YORK
(US) B.A. WOOLEY et al.: "An Integrated
Per-Channel PCM Encoder Based on
Interpolation", pages 14-20**

(73) Proprietor: **TELEFONAKTIEBOLAGET L M
ERICSSON**
**S-126 25 Stockholm (SE)**

(72) Inventor: **APFEL, Russel Jay**
**7060 Anjou Creek Circle**
**San Jose CA 94120 (US)**
Inventor: **ERIKSSON, Anders Gunnar**
**Slaetbaksvagen 28**
**S-121 64 Johanneshow (SE)**
Inventor: **Svensson, Lars Tommy Edward**
**Eksaetravaegen 28**
**S-127 33 Skaerholmen (SE)**

(74) Representative: **Wennerholm, Kristian et al
TELEFONAKTIEBOLAGET L M ERICSSON
S-126 25 Stockholm (SE)**

Courier Press, Leamington Spa, England.

## Description

### Background of the invention
### Field of the invention

The present invention relates generally to digital telecommunications systems apparatus and more particularly to a new interpolative analog-to-digital converter wherein input voice signals in analog form are converted to digital form prior to transmission.

### Description of the prior art

Prior art telecommunications apparatus for converting voice signals into digital format for transmission typically include a subscriber line interface circuit (SLIC) that provides a two-wire to four-wire conversion and line feeding operation using transformer coupled techniques plus additional circuitry to handle supervisory test and ringing functions, transmit and receive analog filters and a CODEC which does the actual conversion of the analog signals to digital PCM and the PCM signals back to analog signals. Integrated circuit manufacturers are presently attempting to replace these individual circuit components with integrated circuits which accomplish the various functions as they are presently performed; that is, a single channel monolithic CODEC replaces the CODEC function, single channel filters replace the filter function and a monolithic SLIC replaces the transformer and its associated hardware. Since prior art systems were based on a system architecture that was developed a number of years ago and took advantage of components available at that point in time, a simple replacement of components using LSI technology does not use such technology to its fullest advantage.

Prior art systems perform a number of functions which can be divided into three major catagories. (1) high voltage analog interfacing to subscriber line, (2) processing of the voice signal including two-wire to four-wire conversion, filtering and coding, and (3) interface to the digital world including the PCM signal paths and control line from a processor or controller. In providing a new system, it is reasonable to partition the new system along these technologies.

The analog interface to subscriber line requires both high current and high voltage devices and therefore is best implemented in a bipolar high voltage technology. High voltage bipolar technologies are not dense technologies and therefore this device should be kept as simple as possible. The signal processing and digital interface functions can both be implemented in low voltage technology. The low voltage technologies are high density LSI technologies with the optional choice for cost being n-channel MOS.

At present, signal processing is in the form of analog two-wire to four-wire conversion followed by analog filtering, analog sample-and-hold operations, and analog-to-digital or digital-to-analog conversion. The companding functions are also done in the analog-to-digital and digital-to-analog converters in an analog manner. Since n-channel MOS is optimal for digital functions, it would appear practical to base a new system on digital signal processing. However, there has heretofore been a reluctance among the designers of such systems to use digital filters because such devices are complex structures requiring a great deal of hardware and dissipate a substantial amount of power.

In order to implement a digital filter structure, an analog-to-digital and digital-to-analog converter is required. However, in the subscriber line audio processing functions, analog-to-digital and digital-to-analog converters are required along with analog filters so no penalty is paid by having such converters. They are just placed in different parts of the system. Digital filters also require a reasonable amount of initial overhead at the outset. An arithmetic processing unit, read only memory (ROM) and random access memory (RAM) are all required to implement the filter. Therefore, a very simple filter requires nearly as much silicon hardware as a complex filter. Although filters required for the subscriber line functions are complex filters, the digital filter is cost effective when compared to the analog filter.

In comparing filter cost (based on silicon area) versus the complexity (or the degree of difficulty) and performance required from the filter, it has been noted that with analog types of filters the cost increases a linear proportion to the complexity. However, in the case of digital filters, even though a high initial cost is paid, the cost of adding additional complexity is greatly reduced. One reason for this is that digital filters can multiplex and time share hardware where analog filters cannot. The digital filter also requires no precision components whereas the analog filter requires a large number of precision components (which may have to be trimmed and must have very low, drift) in order to meet performance specifications. The digital filter can also be more accurate by just adding more bits in the computational path.

Another problem in using digital filters for such applications has been power dissipation due to the large amount of arithmetic processing. Typical digital filters require high speed multipliers which dissipate a great deal of the power. Telecommunications systems require very low power dissipation and analog filters have tended to be of lower power than digital filters. Consequently, prior art implementations have historically used analog filters rather than digital filters.

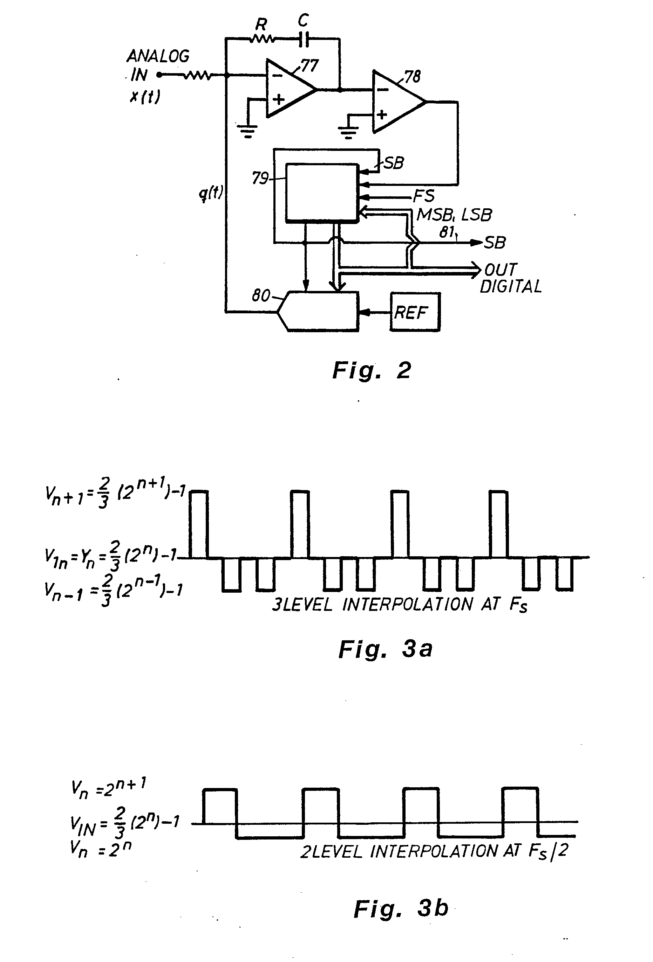

Referring now to Fig. 2 of the drawing, a schematic block diagram is shown illustrating a simplified version of a prior art interpolative encoder. In the basic encoding loop, negative feedback is used to minimize the average difference between the analog input x(t) and its quantized representation q(t). The difference between x(t) and q(t) is integrated and summed with the instantaneous difference between x(t) and q(t) by an integrating amplifier 77 and the polarity of the result is detected by a comparator 78. The output of comparator 78 is fed into shift control logic 79 which directs an increase or decrease in the quantized signal q(t) generated by a digital-to-analog converter (DAC) 80. In the preferred form logic 79 includes an 8-bit bidirectional shift register that acts as a digital accumulator filling with ones at the bottom (the least significant bit LSB) and zeros at the top. As the register fills with logical 1's the magnitude of the quantization increases. The polarity of the quantization is also monitored by logic 79 and is output in the form of a sign bit SB on line 81. The magnitude is output on lines 78.

Additional details and operational characteristics of a circuit similar to that illustrated may be found in an article by Bruce A. Wooley and James L. Henry entitled "An Integrated Per-Channel PCM Encoder Based On Interpolation", pp 14—20, IEEE Journal of Solid-State Circuits, Vol. SC14, No. 1, February 1979.

Summary of the present invention

Although the above-described interpolative A/D converter and others disclosed in the prior art may be used in a telecommunications system, such converters suffer from several disadvantages. Since the comparator output is sampled at a frequency $F_s$ which is much greater than the input frequency range of interest and is used to control the shift register to determine the new quantized output, the DAC output must change at every sample because a 1-bit code allows only two conditions, i.e., increase and decrease, and does not allow a state where the DAC output remains constant. More specifically, the shift register control only allows the DAC input to be 0, $\pm00000001$, $\pm00000011$, $\pm00000111$, $\pm00001111$, $\pm00011111$, $\pm00111111$, $\pm01111111$, or $\pm11111111$. As pointed out in Candy et al, "A Per-Channel A/D Converter Having 15-Segment μ-255 Companding"; pp 33—42, IEEE Trans. on Communications, Vol. com-24, No. 1, January 1976, these codes have been chosen to correspond to 4/3 times the end points of the μ-law chord characteristics so that the average of any two points is the end point of a μ-law chord. The shift register controller allows only 17 levels in the system, e.g., 8 positive levels, 8 negative levels and 0. The feedback loop will cause the A/D to try to force the integrator output towards zero so that the integral of q(t) will try to equal the integral of x(t).

For DC input signals with proper damping set by the resistor R and capacitor C, the system will generate a pattern such as that illustrated in Fig. 3(A) which is a three level oscillation around the input signal. The authors describe a 256 kHz system wherein 32 samples are effectively averaged two steps at a time. Each two reading step is averaged by taking the lower of the two readings and dropping the 4/3 scale factor. For example, if one reading is 4/3 of the end point n, the next lower reading is 2/3 the end point n, and the average is end point n which is the same code as the lower reading. This average reduces the number of samples to 16 and they are averaged in a parallel 12-bit adder to give a 12-bit result. The resolution in the adder is a function of the number of samples (N) averaged and the resolution of each sample, i.e, $\log_2$ N×resolution of an individual sample=resolution of result.

Kawahara et al, infra, and others have also described the use of a 512 kHz system with averaging done only down to 32 kHz. However, all these systems exhibit several problems the reasons for which will now be discussed along with solutions.

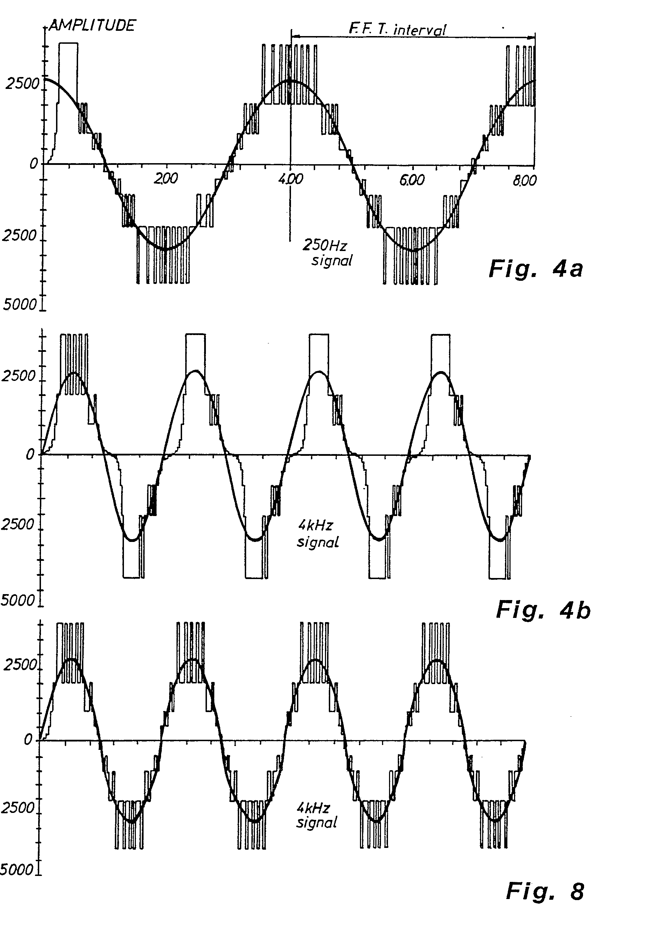

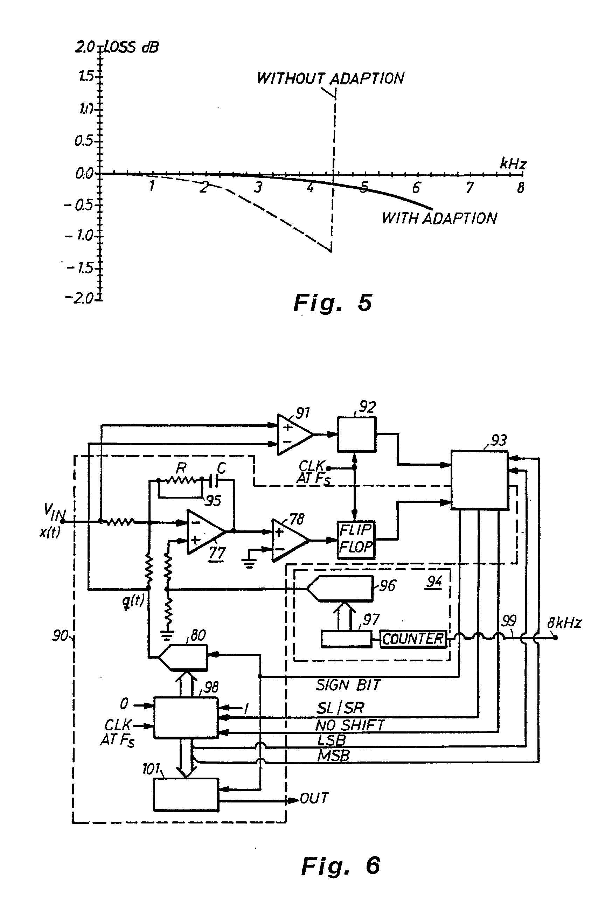

1. Frequency dependent gain.—With regard to this problem, the sample rate and the number of levels in the converter are the basic system constraints. As the input frequency increases, the system has more trouble tracking the signal as shown in Figs. 4(a) and 4(b). As will be noted in Fig. 4(a), the system tracks fairly well at 250 Hz. However, when the frequency is increased to 4 kHz the tracking deteriorates as illustrated in Fig. 4(b). For a signal to go from +full scale to —full scale takes a time of (2M−1)T and maximum frequency at full amplitude that the system can generate is $F_s/2(2M−1)$. For the 8 level system, this is $F_s/30$. However, near these frequencies, errors are created. Even at lower frequencies, the signal distortion is significant. A frequency dependent gain can be observed by measuring the output component of the A/D converter at the input signal frequency and the results for a 256 kHz sample rate and an 8 level system are shown in Fig. 5. Increasing the sample rate to 512 kHz improves the response at low frequencies but frequency dependent gains still occurs at higher frequencies. This can cause significant problems in the system if it is not corrected.

2. DC signals are limited as a function of sample rate.—Limited DC resolution is due to the difference between levels and the number of samples averaged. In the above-described system, every other level represents a level halfway between the two levels. The three level oscillation in Fig. 3(a) can be replaced with a two level oscillator at $F_s/2$ as shown in Fig. 3(b). The two levels are spaced 2:1 apart and the resolution is determined by the number of samples averaged. In the approach taken by Candy et al, supra 16 samples are averaged so that the resolution of signal is approximately one part in 32 or similar to the resolution obtained in following the μ-law or A-law practice. A higher sample rate, i.e., 512 kHz would allow twice as many samples to be averaged and would allow more resolution, i.e. 1:64. The resolution of these systems can be said to be 1:($F_s/F_{out}$) where $F_{out}$ is the output sample rate.

3. Dynamic range is limited as a function of sample rate.—Limited dynamic range is a problem that is similar to limited resolution. The dynamic range is the ratio of the smallest level resolved to the largest. The smallest level resolved is near zero and is $X_0(F_{out}/F_s)$ where $X_0$ equals the output for the code 00000001. The largest level is $2^M X_0$ where M is the number of levels (positive or negative) in the DAC. The dynamic range is therefor $2^M F_s/F_{out}$ and can be increased by either increasing M or $F_s$. However, if M is increased without changing $F_{sD}$, the frequency where tracking problems occur is lowered.

4. Limited high frequency signal capability.—When high frequency signals are applied to the converter which cannot be tracked, the output tends to collapse and go 180° out of phase with the input. Under some circumstances in-band signals (low frequency) are also created by the non-tracking mode which are less than −30 dB below the input level.

5. Out-of-band signals generating in-band signal components.—The averaging digital filter used in the above-described circuit is not optimum configuration because it does not adequately filter out all out-of-band signals and can cause folding of out-of-band signals into the passband. Out-of-band signals are generated not only by out-of-band input signals but by the A/D switching at the high sample rate of 256 kHz or 512 kHz. Signals between 4 and 8 kHz are not adequately attenuated and will fold back into the passband (assuming a 0 to 3.4 kHz passband). Signals near 12 kHz will also fold back into the passband with only −13 dB attenuation. Therefore, it seems that this A/D converter would require a precision prefilter in order to be useful for voice band signal processing.

The A/D generates out-of-band signals in the range of −20 to −50 dB below the input level and some of these signals will fold back with less than −30 dB attenuation and will increase the in-band noise. They can also increase the system signal-to-noise ratio. The interpolator with 512 kHz input and 32 kHz output averaging filter has better performance. This filter requires complex filtering afterwards but can eliminate all but a simple prefilter. Signals falling within the bands of 32 to 36 kHz, 60 to 68 kHz, etc., still fold directly into the passband and more attenuation is desirable in those bands.

The object of the present invention is to provide an improved analog-to-digital converter for use in the audio processing portions of telecommunications apparatus.

The invention is characterized as it appears from the characterizing part of the appended claim 1.

The numerous advantages achieved in accordance with the present invention will no doubt become apparent to those skilled in the art after having read the following detailed description of the preferred embodiments which are illustrated in the several figures of the drawing.

In the drawing

Fig. 1 is a block diagram illustrating the system architecture of a subscriber line audio processing circuit;

Fig. 2 is a block diagram schematically illustrating a prior art interpolative analog-to-digital converter;

Figs. 3(a) and 3(b) respectively illustrate three-level interpolation and two-level interpolation;

Figs. 4(a) and 4(b) illustrate operation of apparatus in accordance with the prior art;

Fig. 5 is a diagram illustrating the frequency dependent gain characteristic of an analog-to-digital converter utilizing a converter of the type illustrated in Fig. 7;

Fig. 6 is a block diagram illustrating an interpolative A/D converter modified in accordance with the present invention;

Fig. 7 illustrates an alternative embodiment of an interpolative A/D converter in accordance with the present invention;

Fig. 8 illustrates operation of the A/D converter illustrated in Fig. 7;

Fig. 9 is a diagram illustrating signal-to-digital noise ratios for adaptive A/D converter in accordance with the present invention;

Fig. 10 is a block diagram schematically illustrating a circuit for modifying operation of the converter illustrated in Fig. 7;

Fig. 11 is a diagram illustrating operation of a converter with and without the modification illustrated in Fig. 10;

Fig. 12 is a block diagram illustrating a digital decimator filter;

Fig. 13 illustrates a hardware implementation of the filter illustrated in Fig. 12.

**Description of the preferred embodiments**

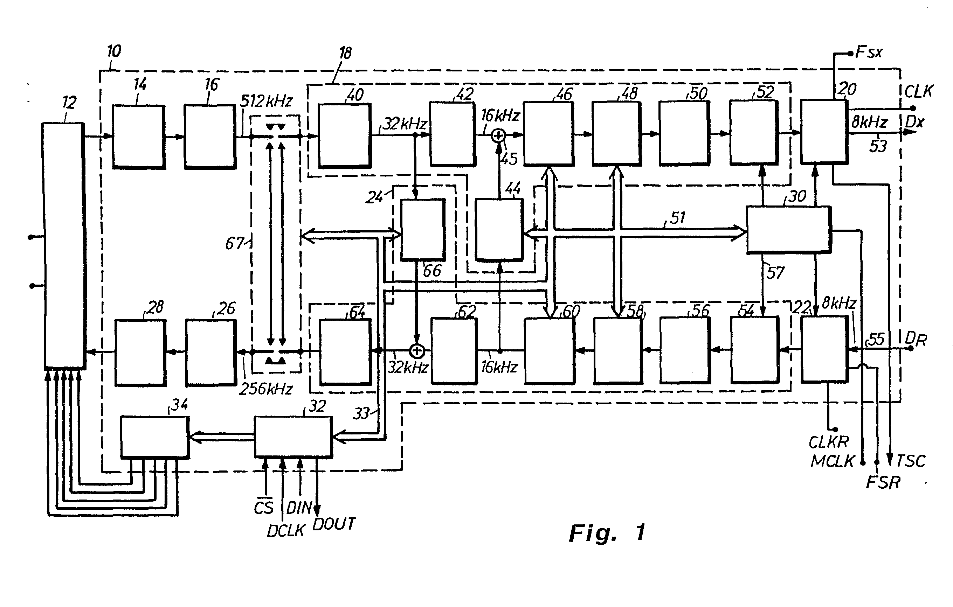

Referring now to Fig. 1 of the drawing, a block diagram is shown of a subscriber line audio processing circuit (SLAC) 10 for use in accordance with a subscriber line interface circuit (SLIC) 12. In general, the SLAC consists of means forming a transmit path including an input filter 14, an analog-to-digital converter 16, digital signal processing circuitry 18 and a transmit register 20. The received signal path includes a receive register 22, a receive signal processing circuit 24, a digital-to-analog converter 26 and an output filter 28. In addition, input/output control means 30 is also included along with additional system control circuitry 32 and SLIC control circuitry 34.

More specifically, the input filter 14 is a simple anti-aliasing filter which is used to prevent signals near the sample rate from folding back into the voice band during later decimation stages. Filter 14 should have at least 10 dB attenuation at 508 kHz (if $F_s$=512 kHz). This can be accomplished using a single pole filter placed at 114 kHz. Delay in this filter is normally 1.4 μ sec.

As will be explained in more detail below, the A/D converter 16 is an interpolative encoder which samples the input analog (voice) signal at a relatively high sampling frequency, such as 512 kHz (or 256 kHz), and generates multi-bit digital words representative of the signal amplitude at each sample.

The A/D converter is a major contributor to system performance and creates most of the errors in the system. Its performance determines the signal-to-noise ratio, gain tracking, idle channel noise, harmonic distortion, out-of-band signal response, intermodulation distortion and can limit frequency response.

The transmit signal processing circuit 18 includes a pair of low pass decimation filters 40 and 42, a balance filter 44, a transmit attenuation distortion correction (ADC) filter 46, a transmit gain adjust circuit 48, a main transmit filter 50 and a digital compressor circuit 52. As will be further explained below, the A/D converter 16 will also accurately convert signals that are above 3.4 kHz and therefore such signals must be attenuated with low pass filters as in a traditional filter system. The filtering is accomplished by means of a series of low pass filters including those shown at 40, 42 and 50 respectively. The low pass decimator filters 40 and 42 are frequency reduction filters. The transmit filter 50 is not only a low pass filter but additionally includes a high pass filter section to perform 60 cycle rejection that is normally done as part of the anti-aliasing filter in a telephone system.

Digital filters require a great deal of computation and the higher the frequency the more the computaton required, because a higher rate of computation is required. Therefore it is important from an economic view point to reduce the number of computations and to reduce the sampling rate as rapidly as possible. Accordingly, the function of filters 40 and 42 is to reduce the sampling rate. More specifically, filter 40 reduces the sampling rate from 512 kHz to 32 kHz by providing a low pass filter function. This filter must assure that no signals above 32 kHz get folded back into the pass band of from 0 to 3.4 kHz. Moreover, filter 40 should have passband characteristics which are as flat as possible. It is not necessary nor overly critical that the pass band characteristic be kept absolutely flat, however, as this can be compensated for in additional digital filter sections.

One advantage of the use of digital filters is that since they have exactly precise characteristics, other filters can be used to compensate for the effects of a preceding filter. In using an analog filter it is very difficult to use a subsequent filter section to cancel out the effects of an earlier section because filter variation is due to the components of the filter.

The 32 kHz signal out of filter 40 is then fed into a second low pass decimator filter 42 which further reduces the frequency to 16 kHz. This filter must insure that there are no components folded back into the pass band and that no components exist at its output that would represent frequencies greater than 12.6 kHz, which is 16 kHz less 3.4 kHz. Although these two filters could be combined into one filter structure, they are effectively split in two to provide 32 kHz and 16 kHz signal points for use by other circuit components.

Bypassing filters 46 and 48 for a moment, the main transmit filter 50 provides both low pass and high pass filtering function. The low pass filtering function provides a low pass filter with a roll off of 3.4 kHz to 4.6 kHz which is analogous to the function provided by analog filters in the prior art systems. In addition, this filter provides attenuation correction to compensate for the effects of filters 40 and 42 and any effects caused by the prefilter 14. The high pass section of this filter provides 60 kHz rejection and rejects any low frequency signals which are not desirable to be transmitted in a telephone system. The output of filter 50 is a linear code. The choice of a linear code is required to keep good signal-to-noise performance in the system as well as to allow easy processing of the signals.

The digital compressor 52 uses a digital algorithm to convert the linear code to either a μ-law or an A-law code which is required in some telephone systems. If a linear code output is desired, this block can be bypassed in the system. The output of the compressor is fed into a transmit register circuit 20 which when controlled by system control signals input at 21 will transmit the data to a telephone switch coupled to transmit terminal 50. The functional units described thus far are somewhat analogous to the traditional functions accomplished by the transmit filter and A/D converter of prior art circuits. Traditionally, in prior art circuits, gain adjustment means have been provided in front of the transmit block of the system by means of a gain amplifier of some sort. As illustrated, the gain function is performed by a gain adjust circuit 48 which provides gain by multiplying the digital word received from decimator 42 by a digital constant. The digital constant is user programmable and can be accurately programmed such that the gain has a very wide range of variation, ranging from +12 dB to minus infinity dB essentially, as determined by proper choice of gain control words that the user programs into the device.

In the prior art systems, the gain must be programmed by some manual adjustment of the system. As shown in Fig. 1 the gain is programmed via a control I/O bus 51, there are no physical components to change and the gain can be programmed at installation under computer control greatly saving cost and time to the manufacturer. The balance filter 44 is used to achieve a transhybrid balance function as will be further described below.

Referring now to the receive path, signals received at terminal 55 are input to receive register 22 and are then input to the processing circuitry 24 which includes a digital expander 54, a main receive filter 56, a gain adjustment circuit 58, receive attenuation distortion correction filter 60, a pair of low pass interpolator circuits 62 and 64, and an impedance filter 66.

Expander 54 functions under program control input at 57 to take either a μ-law or an A-law code

and convert it to a 12 or 13 bit linear code as in the transmit section. If the control word indicates that the input word is linear, the expander may be bypassed. The input sample rate of the system is 8 kHz.

The object of the receive path is to simplify the receive filter which presently must filter an 8 kHz component using a low pass filter technique. Additionally, the present receive filters must compensate for distortion caused by low sample rate. This distortion is known as sin X/X distortion and causes an apparent attenuation of signals when the signal frequency gets to be an appreciable percentage of the sample rate. For instance, a 3.5 kHz signal in and 8 kHz sampling system has about 2 or 2.5 dB of attenuation that must be corrected for.

Filtering is accomplished during the three filters 52, 62 and 64. The main receive filter 56 is a low pass device similar to the low pass component of filter 50 and runs at 16 kHz, whereas the high pass section of filter 50 runs at 8 kHz. Filter 56 receives an 8 kHz signal but outputs a 16 kHz signal. It must therefore have a considerable amount of attenuation in the band between 4.6 kHz and 8 kHz in order to reject any folded frequencies and to reject the 8 kHz component that is present due to the sampling rate. Whereas, the transmit filter 50 is both a low pass and a high pass filter, filter 56 is only a low pass filter.

The reason for the low and high pass components in the transmit circuit, and only a low pass in the receive filter is that in the transmit path, since the signal is received from a telephone line and such lines typically run along side the power lines, it is very easy to pick up 60 Hz signals in the U.S. and 50 Hz signals in Europe. Some of the signal unfortunately feeds into the telephone system. The high pass filter section 50 is designed to reject the 60 Hz signals and once the signals have been rejected and the system is in digital form, there is no way for 60 Hz signals to get fed into subsequent digital sections. As a result, there is no need for the 60 Hz filter in the receive path.

The output of filter 56 is input to a gain adjust circuit 58 and then into a receive attenuation correction (ADC) filter 60, both of which will be further described below.

The first low pass interpolator circuit 62 receives a 16 kHz input signal from circuit 58 and develops a 32 kHz output signal. It functions as a low pass filter, the purpose of which is to greatly attenuate the 16 kHz component. Since the output is at 32 kHz, this filter introduces a 32 kHz component.

The second low pass interpolator circuit 64 is also a low pass filter which outputs either a 256 kHz (or 128 kHz) signal in the present system to provide low pass filtering of the 32 kHz components and to introduce some components of lower magnitude at the higher frequencies. Filters 62 and 64 are mainly concerned with filtering the high frequency components. If they are not perfectly flat in the pass band such performance is highly predictable and can be compensated for by filter 56, which in the present system it does because filters 62 and 64 do attenuate some of the signals around the high end of the pass band, i.e., around 2 or 3 kHz. Accordingly, filter 56 is provided with a compensation network that compensates for the attenuation caused by filter 62 and 64.

The output of filter 64 is then fed into the D/A converter 26 which converts the signals to analog form and passes them through the output filter 28. In telephone systems, the high frequency components must be at least 28 dB down from the low frequency components. At a 256 kHz sample rate, the signal is 28 dB lower than the component at 3.4 kHz. Thus, theoretically no post filter or smoothing filter is required. However, in the present system, the filter 28 is included for safety purposes.

Since the interpolative A/D converter is a highly over sampled system with the information of interest in a lower frequency band than the output of the system, digital filter such as those shown at 40, 42, 46 and 50 in Fig. 1 are required to remove the high frequency error components generated by the converter, to average and smooth the low frequency signal components, and to do any other low frequency filtering required. The digital filtering can be accomplished with a variety of different architectures using finite impulse response (FIR) and/or infinite impulse response (IIR) filters to implement the system.

In the preferred form of the device generally illustrated in Fig. 1 of the drawing, the low pass decimator 40 is comprised of a four tap FIR filter and two 3-tap FIR filters, the first of which reduces the 512 kHz signal to 128 kHz, the second of which reduces the 128 kHz signal to 64 kHz, and the third of which reduces the 64 kHz to 32 kHz. The second low pass decimator 42 is embodied as a 5-tap FIR filter which reduces the 32 kHz signal to 16 kHz, the transmit ADC filter 46 is an 8-tap FIR filter. Transmit gain adjust filter 48 is a one tap FIR filter and main transmit filter 50 is a three IIR filter device including two low pass filters of the canonical form and one high pass filter of the coupled form. The main transmit filter reduces the 16 kHz signal to 8 kHz. The balance filter 44 is an 8-tap FIR device.

The system allows both the incoming audio and a portion of the outgoing (receive) signal to flow into input filter 14. But since the outgoing signal generated is known as well as the time required for it to come back around through the system, the balance filter 44 can be used to generate a cancellation signal which added into the transmit path at 45 will cancel out the returned signal. Moreover, even though the line characteristics are not initially known, the characteristics of the system are known. However, the user can determine the line characteristic and program filter 44 to provide proper balance and since filter 44 is programmable in digital form such cancellation can be very accurately accomplished.

The main receive filter 56 includes 2 canonical IIR low pass filters which increase the received signal from 8 kHz to 16 kHz. Receive gain adjust filter 58 is a one-tap FIR filter, receive ADC filter 60 is an 8-tap FIR filter, and low pass interpolator 62 is a 5-tap FIR filter which increases the 16 kHz signal out of filter 60 to 32 kHz. The second low pass interpolator is comprised of three 3-tap FIR filters which respectively increase the 32 kHz signal to 64 kHz, 128 kHz and 512 kHz.

Impedance filter 66 is a 4-(or 8) 8-tap FIR filter which is used to match the line characteristics. More specifically impedance filter 66 can be used to modify the input impedance of the system as seen at the 2-wire system input port. Filter 66 effectively feeds the voltage generated at the input port back around and into the incoming signal. If done with proper amplitude and polarity the value of the effective input impedance can be changed to match the characteristic impedance of the telephone line. Control of the impedance of filter 66 thus makes it possible to reject echoes and to match different input lines. However, modifying the input impedance makes the gain of the system frequency sensitive. But, the transmit and receive ADC filters 46 and 60 can be programmed to compensate for any such attenuation distortion created by use of filter 66. The gain adjust filters can also be used to add built in losses for eliminating transmission problems such as ringing and oscillation.

The test loop 67 is provided to permit testing of either the device or the line and may be used to facilitate the selection of coefficients for various filters.

The SLAC also includes a serial control interface 32 to a digital control computer for programming a number of functions on the device. The interface has a serial control bus 33 which is used to program the transmit and control time slots for the SLAC as well as setting the transmit and receive gain of the device. It has a power down function as well. Timing inputs include a data clock DCLK, data input DIN, data DOUT, and chipselect $\overline{CS}$ for the serial interface, a master clock MCLK for the time control of the ALUs, transmit and receive clocks CLKX and CLKR, transmit and receive frame synchronization pulses FSX and FSR and a time slot strove TSC for the interface to the PCM system. The time slot assignments are with respect to the frame synchronization pulses FS. When the transmit path goes active, a time slot strobe pin (TSC) is pulled low to drive a tri-state buffer if that is required in the system. The transmit and receive PCM buffers have separate clock inputs in order to be able to operate asynchronously, but in most systems the transmit and receive clocks will be in common. The frame synchronization pulses are also separate for transmit and receive but in most systems a common pulse will be used, and if different time slots are required, this can be programmed in on the time slot selection control input.

Using the serial control bus 33 transmit and receive time slot information is programmed into the device to determine when it is to transmit and receive data; coefficients for the impedance filter 66, balance filter 44, transmit ADC filter 46 and receive ADC filter 60 are all programmed in one byte at a time; and the transmit and receive gain adjust coefficients are also programmed in. All of this data can be read back out on the DOUT line of bus 33 under appropriate control. Additionally, the device can be programmed into special configurations using bus 33. For example, the device can be configured to operate using μ-law, A-law or linear coding.

Furthermore, the four programmable filters 44, 46, 60 and 66 can all be set to default values, i.e., the impedance filter 66 and balance filter 44 can be set to zero, and the two ADC filters 46 and 60 can be set to unity. The gain adjust filters 48 and 58 have default values that can be set at unity. The receive gain adjust filter 58 has a second default value of zero for cutting off the receive path.

The test condition is set by programming in a command which modifies the input to the various filters, i.e., the output of the low pass interpolators 64 is fed into the low pass decimator 40 for digital loopback, and for analog loopback, the output of the A/D converter 16 is fed into the D/A converter 26. These operations are of course accomplished under program control. An additional feature of the device is that in the output of the SLIC, a TTL latch is provided by which the outputs are programmable via control words on the serial interface bus 33.

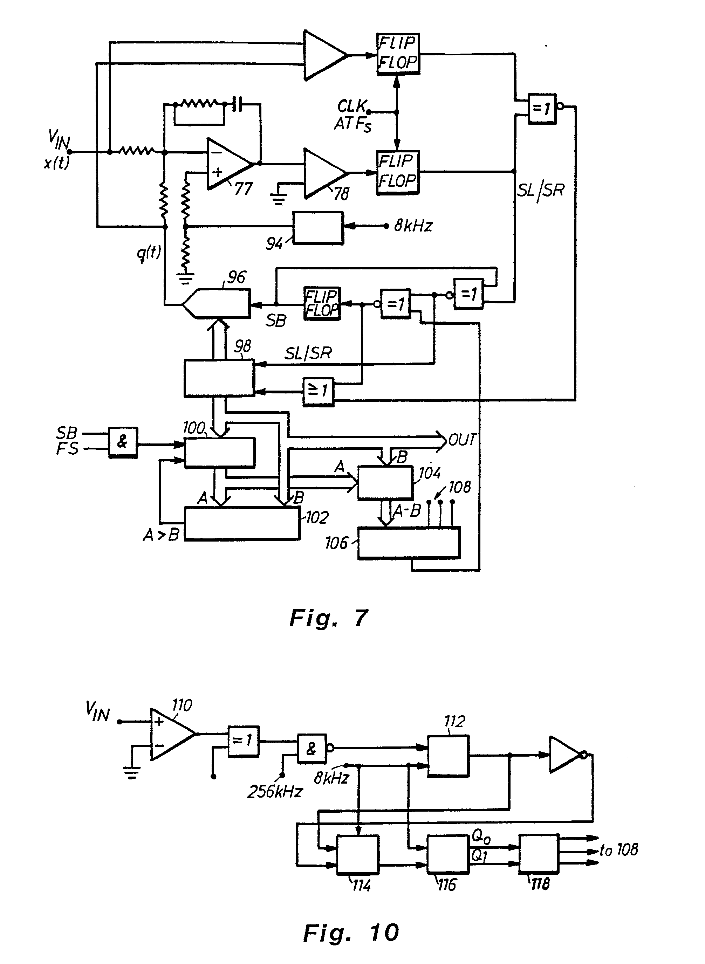

Referring now to Fig. 6 of the drawing, an improvement over the A/D converter shown in Fig. 2 is illustrated. Although somewhat simplified in form, the portion of the circuit enclosed within the dashed lines 90 is essentially the same circuit illustrated in Fig. 2. A second comparator 91, a flip-flop 92 and additional control logic 93 have been added to generate a 2-bit code rather than the 1-bit code developed by the embodiment of Fig. 2, and a digital auto-zero circuit 94 has been added to add offset voltage to amplifier 77.

The additional comparator 91 is used to sample the instantaneous difference between the input x(t) and the quantized output q(t). Damping resistor R is no longer needed and is shown shorted by a line 95. As a result, the original comparator 78 compares only the integral of the delta signal (x(t)−q(t)). The two comparator system has no overshoot or undershoot (beyond one level) and does not need analog damping.

With one comparator only two new states were possible—an increase or a decrease from the previous value. With two comparators it is possible for q(t) to have four possible new states. The extra states can be increased (or decreased) by a greater (or less) amount, or stay the same. In the present system, the only extra state causes the output to remain constant. The ability to remain at a particular level insures that for a DC input the system will oscillate between the two levels that bracket the input, changing at the sample rate. This is an improvement over the one comarator system which, as shown in Fig. 3(b), can only be reduced to a two level oscillation at half the sample rate. The second comparator gives an effective doubling of information (for DC signals) and provides 6 dB more dynamic range and 6 dB more resolution with no increase in sample rate or number of levels.

The second comparator also provides an additional 2.5 dB of dynamic range by allowing the signals in the DAC 80 to be 2.5 dB lower. The one comparator system requires that the maximum DAC output be 4/3 the maximum input level since that level is represented by the system oscillating between 11111111 ($Vin_{max} \times 4/3$) and 01111111 ($Vin_{max} \times 2/3$). The two comparator system can hold the output at 11111111 to represent $Vin_{max}$ and therefore with the same full scale range, it can use levels that are 3/4 those in the one comparator system. This allows 2.5 dB more dynamic range. However, the digital signal processing must be modified to use the two comparator system. No longer can every two samples be averaged by using the digital code of the lower reading and therefore, the average (or other signal processing algorithm) must be applied to all samples.

The auto-zero circuit 94 includes a DAC 96 and a pair of 6-bit up/down counters 97. The counters integrate the sign bit of the 8 kHz which is developed in transmit filter 50 in front of its high pass filter section and fed back via lead 99. If an offset exists in the system, the counters 97 will count up or down until the six-bit code (sign bit plus five magnitude bits) fed into DAC 96 causes it to develop an output level suitable for input to amplifier 70 to compensate for the offset. Thereafter the number of plus and minus sign bits will remain the same and the counters 97 will just toggle back and forth. The lower six bits in counters 97 are used as damping for reducing the frequency of any toggle to below the passband of the system such that if any toggling exists, it will be at a low frequency and be filtered out by subsequent high pass filter of transmit filter 50.

Another independent improvement to the system is illustrated in Fig. 7 and utilizes an adaptive method of controlling the shifting process in order to allow more levels to be used to obtain greater dynamic range but remove unneeded levels to improve frequency response. In addition to the components of the embodiment illustrated in Fig. 6, this embodiment includes a peak value register 100, a comparator 102, a subtractor 104 and a comparator 106. The adaptive algorithm is based on the fact that the system loses track of high amplitude signals as frequency increases because it has difficulty following the signal. The major problem occurs as the signal goes through zero where the quantizer has many low level signals and the input is changing at its maximum rate. This is the problem demonstrated in Fig. 4(b).

The levels near zero contain limited information for large amplitude AC signals and if they can be removed, the system accuracy will not be significantly reduced. The adaptive algorithm senses the peak magnitude during each cycle and removes an appropriate number of levels around zero to allow the system to track the input signal. More specifically, the peak value of the quantized signal in register 98 is stored in the peak value register 100 and the stored peak value is compared to the present value by the comparator 102. At the same time, the present value is also subtracted from the peak value by the subtractor 104 and the difference is compared to a reference input to comparator 106 at 108. However, the subtractor output is not simply the difference between the two inputs, but rather is the difference between the number of ones in each of the inputs A and B.

The output developed by comparator 106 causes the sign bit (SB) to change. As the quantized value goes toward zero, the levels around zero are removed by skipping over them and changing the sign bit. The level at which the sign bit is changed is determined by the peak level. In the adaption illustrated, it is five levels below the signal peak (unless the peak level is 00001111 or lower in which case the adaption reverts back to normal operation) and removes a different number of levels dependent upon the input amplitude keeping ten active levels.

The peak value must be able to decay as the signal level changes. This can be accomplished in numerous ways. For example, (a) by reducing one level at each zero crossing, (b) by reducing the level if a particular level is not reached for a fixed period of time (such as 125 μ sec in a PCM system with final output at 8 kHz sample rate), or (c) by reducing it at a fixed periodic rate. The implementation presently used and illustrated in Fig. 7 reduces the peak level at each zero crossing. This adaption technique reduces the number of active levels from 17 to 10 and the maximum frequency that can be tracked is increased from $F_s/32$ to $F_s/18$. The penalty paid is a very slight increase in signal-to-quantization noise for AC signals. The increased noise is due to the removing of levels near zero. However, the levels removed represent signals which are less than 1% of the period of a sign wave and the increase in noise is minimal.

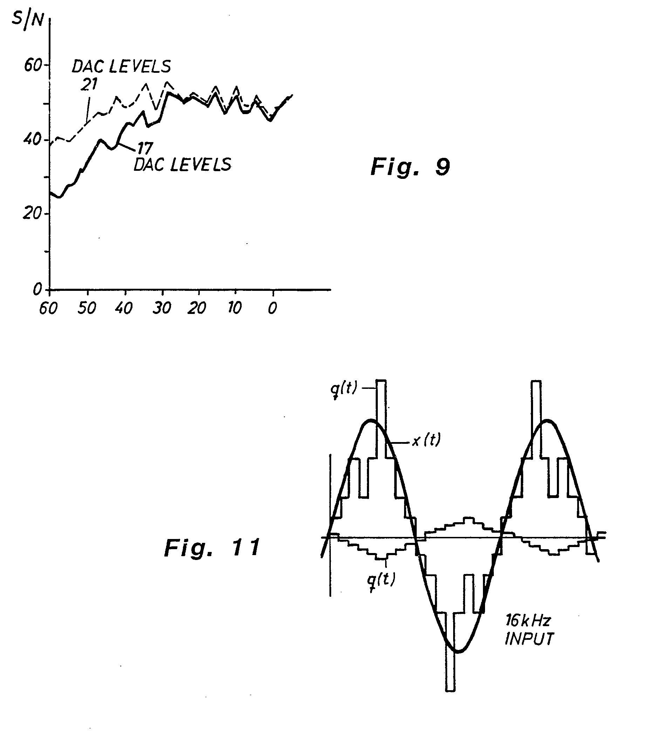

The frequency dependent gain characteristic is also modified and pushed out higher in frequency with much less effect on low frequency signals as shown in Fig. 5. Figs. 4(b) and 8 show the response of a 0 dB, 4 kHz signal with and without adaption respectively. This scheme gives frequency response benefits without an increase in sample rate and with no real penalty in performance, specifically dynamic range, resolution, and signal-to-noise ratio.

The adaption scheme can allow the system to increase its dynamic range without the penalty to frequency response. The DAC illustrated in Fig. 2 uses 17 levels and has just enough dynamic range and resolution for the application. It can only be increased by an increase in sample rate and/or the addition of more levels. However, to add more levels would require a higher sample rate because the frequency response characteristic would not be acceptable otherwise. With the adaption scheme shown in Fig. 7, more levels around zero can be added without degrading frequency response because they will only be used for very low signals.

A system using a 10-bit DAC with 21 levels from 0000000000 to ±1111111111 would still use only the five highest levels as indicated by the peak register, and would have an additional 12 dB of dynamic range since the lowest level would now be $Vin_{min}$ instead of $Vin_{max}/256$. The levels added would be near zero as the maximum level would always be equal to $Vin_{max}$ (or 4/3 $Vin_{max}$ if only one comparator is used). The number of levels near zero that can be added is limited by the noise of the system and as long as there is the same relative accuracy of all DAC levels, the system performance is expanded to cover another 12 dB of dynamic range. Fig. 9 shows the signal-to-noise ratios for 17 level and 21 level systems using the adaptive algorithm.

The adaptive algorithm described above improves frequency response and dynamic range at a given sample rate. It only operates on the magnitude of the input signal and behaves identically independent of frequency.

A further addition can be made which allows the system to modify the adaption based on the input frequency. This addition senses that the input frequency exceeds a frequency where the A/D converter can accurately track the input and modify the adaption by removing more levels around zero. This will increase noise for high frequency inputs but will allow the input to be tracked up to higher frequencies. A modification which enables such capability is the addition of the circuit shown in Fig. 10 to the circuit of Fig. 7. This circuit compares the sign bit of the input (developed by a comparator 110) with the quantized sign bit (from DAC 96) over a 32 sample period as determined by a 4-bit counter 112. If they are different for more than 50% of the samples, the system is not accurately tracking the input and the adaption is modified by removing more levels. This system allows the A/D converter to track the input using 10 active levels first, and then reducing the number of levels to 8, 6 and 4 as determined by the 6-bit counter 114, the two-bit counter 116 and the decoder 118. See the following table

| $Q_0$ | $Q_1$ | Adaption Status |
|:---:|:---:|:---:|
| 0 | 0 | uses 10 levels |
| 0 | 1 | uses 8 levels |
| 1 | 0 | uses 6 levels |
| 1 | 1 | uses 4 levels |

This creates switch-over points near $F_s/18$, $F_s/14$, $F_s/10$ and $F_s/6$. Above $F_s/6$ the system does not track further.

The system could also be modified to start out using all 17 (or 21) levels and then remove levels as it senses that it is not tracking. This dynamically changed adaption has a fast "attack" time (32 samples) but must have a long "decay" time (generated by the 6-bit counter 114) in order to remain stable. Fig. 11 shows the response to a 16 kHz signal with and without this improvement.

Still another area of possible improvement resides in the digital signal processing of the results of the A/D converter. *Candy et al,* supra, have described the use of averaging filter to reduce the output frequency of the A/D converter, and *Kuwahara et al,* in "interpolative PCM CODECS with Multiplexed Digital Filters", p. 174, *Proceedings 1980 IEEE International Solid-State Circuits Conference,* February 14, 1980, disclose the use of an averaging filter to reduce the output frequency to 4 times the final output and then an infinite impulse response (IIR) filter to filter the lower frequencies. However, two key points are missed in these prior art approaches.

The first is that the sample rate is being reduced by the decimation filters and the most important task of the filters is to insure that the frequency components folded into the passband are adequately attenuated. If components in the passband have attenuation distortion, such distortions can be corrected in a filter at or near the final sample rate. Averaging filters do not really give adequate attenuation to out-of-band signals.

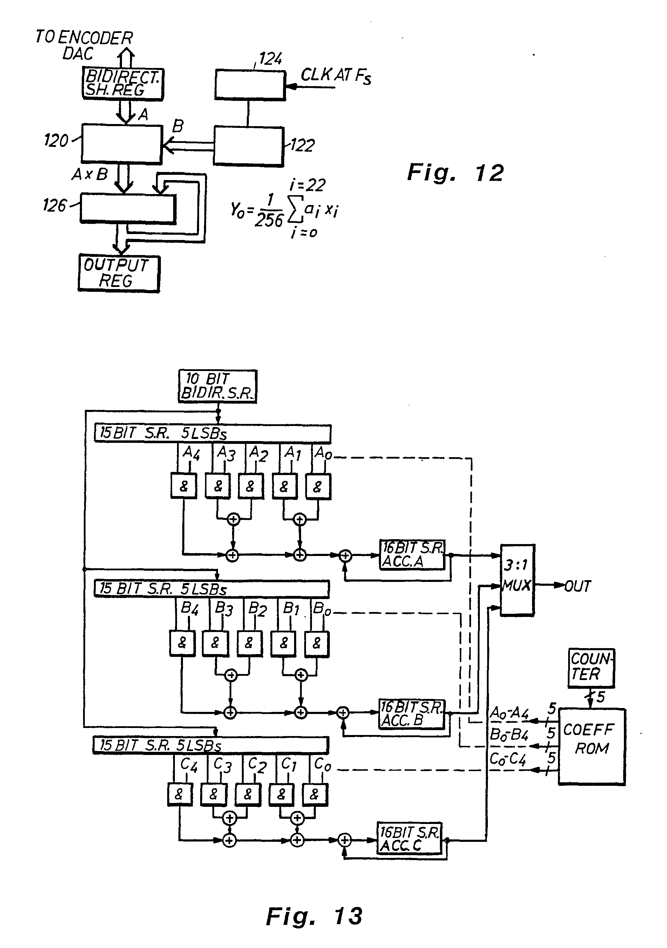

The second point is that the decimation filter used with the A/D should provide adequate attenuation at all bands of width $2F_{pass}$ around all folding frequencies. One way of providing this performance is to place multiple transmission zeros at all folding frequencies. A filter capable of doing this is shown in Fig. 12. This filter includes an arithmetic processor 120, a coefficient ROM 122, a counter 124 and an adder and accumulator 126. The filter equation is

$$Y_0 = \frac{1}{256} \sum_{i=0}^{i=22} a_i x_i \qquad (5)$$

The filter reduces the frequency to $2F_{sfinal}$ and allows a final digital filter to do any signal shaping. This filter includes the composite of all the decimator stages required to reduce the sample rate down to 16 kHz.

This filter provides significantly more protection against out-of-band components than an averaging filter and eliminates the need for all but a simple single pole filter in front of the A/D converter. The filter also processes more than N terms for a frequency reduction of N and allows more resolution and dynamic range for the same A/D converter. The idea of processing more than N terms in a frequency reduction filter requires that the filter have some memory but this can be kept to a minimum as the single filter stage shown in Fig. 13 which has an output at 16 kHz rather than the earlier described circuit which operates with multiple simple filters reducing the sample rate with several intermediate stages. The A/D converter output is used as part of 3 different summations which are stored in memory. Furthermore, the A/D output gets multiplied by 3 different constants and added to each summation. The summations are completed at different times and a new summation begun.

In summary then, an interpolative A/D converter can be improved using any of three independent techniques; (a) By adding a second comparator to give 6 dB (8.5 dB) additional dynamic range and 6 dB more resolution at a given sample rate, (b) By adding an adaption scheme to allow better tracking of high frequency signals and as much additional dynamic range as is needed, limited only by system noise; or (c) By modifying the frequency reduction filter from an averaging filter to a filter that provides more attenuation around folding frequencies and one that processes more samples to improve dynamic range resolution and reduce noise.

**Claims**

1. An interpolative analog-to-digital converter for a subscriber line audio processing unit comprising:
integrating means (R, C, 77) for integrating the difference between an input analog signal x(t) and a quantized signal q(t) to develop an integrated signal;
first comparator means (78) for sampling said integrated signal at a first sampling frequency and for generating first signals of one data state when said integrated signal is positive and of another data state when said integrated signal is negative;
logic means (93) responsive to said first signals and operative to develop a sign bit signal, and shift signals;
shift register means (98) responsive to said shift signals, and operative to develop a series of multi-bit binary words each having a predetermined number of bits and a magnitude determined by said shift signals;
digital-to-analog converter means (80) responsive to said binary words and said sign bit signal and operative to convert said binary words into said quantized signals q(t), said quantized signals q(t) being positive or negative dependent upon the data state of said sign bit; and
digital signal processing means (Fig. 12) for digitally filtering said series of binary words and for developing binary output signals at a frequency of at least twice the highest signal frequency in said input signal x(t), characterized in
second comparator means (91) for comparing said input signal x(t) to said quantized signal q(t) and for sampling the results of the comparison at said first sampling frequency to develop second signals of one data state when said input signal x(t) is greater than said quantized signal q(t) and of another data state when said input signal x(t) is less than said quantized signal q(t);
said logic means (93) being operative to develop a plurality of signals including said sign bit signal a shift left signal, a shift right signal and a no shift signal, and
said shift register means (98) being responsive to said shift left signal, said shift right signal and to said no shift signal, said series of multi-bit binary words having a magnitude determined also by said no shift signal.

2. An interpolative analog-to-digital converter according to claim 1, characterized in that it comprises means (100) for storing the peak magnitude of said binary words generated during each cycle of said input signal x(t);
third comparator means (102) for comparing said peak magnitude to the present magnitude of said binary words and for incrementing said peak magnitude each time said present value exceeds said peak magnitude; and
adaptive means (104, 106) for determining the difference between said peak magnitude and the present value of said binary words and for causing said sign bit to change state when the difference exceeds a reference level.

3. An interpolative analog-to-digital converter according to claim 2, characterized in that said adaptive means includes subtractor logic (104) for subtracting the magnitude of said present value signal from said peak value magnitude to develop a difference signal, and a comparator (106) for comparing said difference signal to a reference signal, and for developing a sign bit change signal for input to said logic means to effect a change of state to said sign bit thereby improving the frequency response of the system.

4. An interpolative analog-to-digital converter according to claims 2 or 3, characterized in that it further comprises
means (110) for determining the sign of the input signal and for comparing said sign to the sign of each said quantized signal q(t) during a predetermined sample period and for changing the value of said reference signal such that the number of active signal levels of said shift register means is correspondingly changed.

5. An interpolative analog-to-digital converter according to claims 1, 2 or 3, characterized in that said digital signal processing means includes filter means (Fig. 12) having multiple transmission zeroes at all signal folding frequencies.

6. An interpolative analog-to-digital converter according to claim 5, characterized in that said filter means includes a coefficient storage means (122), an arithmetic processor (120) for multiplying said binary words by predetermined coefficients stored in said storage means and adder and accumulator means (126) for summing and storing the products of said multiplying operation.

7. An interpolative analog-to-digital converter according to claim 5, characterized in that it further comprises
auto-zero circuit means (94) for developing an offset compensation signal for input to said integrating means to compensate for system offsets.

8. An interpolative analog-to-digital converter according to claim 7, characterized in that said auto-zero circuit means (94) includes counter means for integrating the sign bit of a binary signal developed by said signal processing means, and digital-to-analog converter (96) for converting the output of said counter means to analog form to provide said offset compensation signal.

**Patentansprüche**

1. Interpolations-Analog-Digitalwandler für eine Teilnehmerleitungs-Audioverarbeitungseinheit umfassend eine integrierende Einrichtung (R, C, 77) zum Integrieren der Differenz zwischen einem Eingangs-Analogsignal x(t) und einem quantisierten Signal q(t), um ein integriertes Signal hervorzubringen, eine erste Komparatoreinrichtung (78), um das integrierte Signal abzutasten bei einer ersten Abtastfrequenz und um erste Signale eines Datenzustandes zu erzeugen, wenn das integrierte Signal positiv ist und eines anderen Datenzustandes, wenn das integrierte Signal negativ ist, ein logische Einrichtung (93), welche auf die ersten Signale anspricht und betätigbar ist, um ein Vorzeichen-Bitsignal zu erzeugen sowie Verschiebesignale, eine Schieberegistereinrichtung (98), welche auf die Verschiebesignale anspricht und betätigbar ist, um eine Reihe von Multibit-Binärworten zu erzeugen, von denen jedes eine vorgegebene Anzahl von Bits sowie eine Größe aufweist, die durch diese Verschiebesignale bestimmt ist, eine Digital-Analog-Wandlereinrichtung (80), welche auf die Binärworte und das Vorzeichen-Bitsignal anspricht und in der Lage ist, die Binärworte in die quantisierten Signale q(t) umzuwandeln, wobei die quantisierten Signal q(t) positiv oder negativ in Abhängigkeit von dem Datenzustand des Vorzeichenbits ist, und eine digitale Signalverarbeitungseinrichtung (Fig. 12) zum digitalen Filtern der Reihe von Binärworten und zum Gewinnen von binären Ausgangssignalen bei einer Frequenz von zumindest dem zweifachen Wert der höchsten Signalfrequenz in dem Eingangssignal x(t), dadurch gekennzeichnet, daß eine zweite Komparatoreinrichtung (91) vorgesehen ist zum Vergleichen des Eingangssignals x(t) mit dem quantisierten Signal q(t) und zum Abtasten der Ergebnisse des Vergleichs bei der ersten Abtastfrequenz, um zweite Signale eines Datenzustandes hervorzubringen, wenn das Eingangssignal x(t) größer ist als das quantisierte Signal q(t) und eines anderen Datenzustandes, wenn das Eingangssignals x(t) kleiner ist als das quantisierte Signal q(t), daß die logische Einrichtung (93) in der Lage ist, eine Vielzahl von Signalen hervorzurufen, die das Vorzeichen-Bitsignal, ein Verschiebe-Linkssignal, ein Verschiebe-Rechtssignal und ein Nichtverschiebesignal umfassen und

daß die Schieberegistereinrichtung (98) auf das Verschiebe-Linkssignal, das Verschiebe-Rechtssignal und auf das Nichtverschiebesignal anspricht, wobei die Reihe der Multibit-Binärworte eine Größe aufweist, die auch durch das Nichtverschiebesignal bestimmt ist.

2. Interpolations-Analog-Digitalwandler nach Anspruch 1, dadurch gekennzeichnet, daß er eine Einrichtung (100) zum Speichern der Spitzengröße der Binärworte aufweist, die während jedes Zyklus des Eingangssignales x(t) erzeugt werden, daß eine dritte Komparatoreinrichtung (102) zum Vergleichen der Spitzengröße mit der gegenwärtigen Größe der binären Worte und zum Inkrementieren der Spitzengröße jedesmal dann, wenn der gegenwärtige Wert diese Spitzengröße übersteigt, und daß eine adaptive Einrichtung (104, 106) zur Bestimmung der Differenz zwischen der Spitzengröße und dem gegenwärtigen Wert der binären Worte und zur Veranlassung der Änderung des Zustandes des Vorzeichenbits vorgesehen ist, wenn die Differenz einen Referenzpegel übersteigt.

3. Interpolations-Analog-Digitalwandler nach Anspruch 2, dadurch gekennzeichnet, daß die adaptive Einrichtung eine Subtrahierlogik (104) zum Subtrahieren der Größe des gegenwärtigen Signalwertes von der Spitzenwertgröße enthält um ein Differenzsignal zu erzeugen, und einen Komparator (106 aufweist zum Vergleichen des Differenzsignales mit einem Referenzsignal und um ein Vorzeichenbitänderungssignal hervorzurufen für die Eingabe in die logische Einrichtung, un eine Änderung des Zustandes des Vorzeichenbits zu bewirken, wobei hierdurch der Frequenzgang des Systems verbessert wird.

4. Interpolations-Analog-Digitalwandler nach Anspruch 2 oder 3, dadurch gekennzeichnet, daß dieser außerdem eine Einrichtung (101) zur Bestimmung des Vorzeichens des Eingangssignals und zum Vergleichen des Vorzeichens mit dem Vorzeichen jedes quantisierten Signal a(t) während einer vorgegebenen Abtastperiode und zum Ändern des Wertes des Referenzsignals aufweist, so, daß die Anzahl der aktiven Signal-pegel der Schieberegistereinrichtung ent-sprechend geändert wird.

5. Interpolations-Analog-Digitalwandler nach Anspruch 1, 2 oder 3, dadurch gekennzeichnet, daß die digitale Signalverarbeitungseinrichtung eine Filtereinrichtung (Fig. 12) umfaßt, welche Vielfach-Übertragungsnullen bei allen Signal-Faltungs-Frequenzen aufweist.

6. Interpolations-Analog-Digitalwandler nach Anspruch 5, dadurch gekennzeichnet, daß die Filtereinrichtung eine Koeffizientenspeichereinrichtung (122), einen arithmetischen Prozessor (120) zum Multiplizieren der Binärworte mit vorgegebenen Koeffizienten, welche in der Speichereinrichtung gespeichert sind sowie eine Addierer- und Akkumulatoreinrichtung (126) aufweist, um die Produkte der Multiplikationsoperation zu summieren und zu speichern.

7. Interpolations-Analog-Digitalwander nach Anspruch 5, dadurch gekennzeichnet, daß dieser außerdem eine Auto-Null-Schaltungseinrichtung (94) zur Hervorrufung eines Versetzungs-Kompensationssignales aufweist zur Eingabe in die integrierende Einrichtung, um System-Versetzungen bzw. Regelabweichungen zu kompensieren.

8. Interpolations-Analog-Digitalwandler nach Anspruch 7, dadurch gekennzeichnet, daß die Auto-Null-Schaltung (94) eine Zähleinrichtung zum Integrieren des Vorzeichenbits eines Binärsignales aufweist, welches durch die Signalverarbeitungseinrichtung hervorgerufen wird, sowie einen Digital-Analog-Wandler (96) enthält, um das Ausgangssignal der Zähleinrichtung in eine analoge Form umzuwandeln, um das Versetzungs-Kompensationssignal zu schaffen.

**Revendications**

1. Convertisseur analogique-numérique à interpolation destiné à une unité de traitement audiofréquence pour ligne d'abonné comprenant:

un intégrateur (R, C, 77) destiné à intégrer la différence entre un signal analogique d'entrée x(t) et un signal quantifié q(t) pour produire un signal intégré;

un premier comparateur (78) destiné à échantillonner ledit signal intégré à une première fréquence d'échantillonnage et à produire des premiers signaux ayant un premier état de données lorsque ledit signal intégré est positif et un autre état de données lorsque ledit signal intégré est négatif;

un circuit logique (93) qui réagit auxdits premiers signaux et qui produit un signal de bit de signe et des signaux de décalage;

un registre à décalage (98) qui réagit auxdits signaux de décalage et qui produit une série de mots binaires à plusieurs bits ayant chacun un nombre prédéterminé de bits et une valeur absolue qui est déterminée par lesdits signaux de décalage;

un convertisseur numérique-analogique (80) qui réagit auxdits mots binaires et audit signal de bit de ligne et convertit lesdits mots binaires pour donner lesdits signaux quantifiés q(t), lesdits signaux quantitifés q(t) étant positifs ou négatifs suivant l'état de données dudit bit de signe; et

un circuit de traitement de signal numérique (figure 12) destiné à effectuer un filtrage numérique de ladite série de mots binaires et a produire des signaux binaires de sortie à une fréquence au moins égale au double de la fréquence de signal la plus élevée présente dans ledit signal d'entrée x(t), caractérisé par

un second comparateur (91) destiné à comparer ledit signal d'entrée x(t) audit signal quantifié q(t) et à échantillonner les résultats de la comparaison à ladite première fréquence d'échantillonnage pour produire des seconds signaux d'un premier état de données lorsque ledit signal d'entrée x(t) est supérieur audit signal quantifié q(t) et d'un autre état de données lorsque ledit signal d'entrée x(t) est inférieur audit signal quantifié q(t);

ledit circuit logique (93) produisant plusieurs signaux contenant ledit signal de bit de signe, un signal de décalage à gauche, un signal de décalage à droite et une signal d'absence de décalage, et

ledit registre à décalage (98) réagissant audit signal de décalage à gauche, audit signal de décalage à droite et audit signal d'absence de décalage, ladite série de mots binaires à plusieurs bits ayant une valeur absolue également déterminée par ledit signal d'absence de décalage.

2. Convertisseur analogique-numérique à interpolation selon la revendication 1, caractérisé en ce qu'il comprend un élément (100) destiné à enregistrer la valeur absolue de crête desdits mots binaires qui sont produits pendant chaque cycle dudit signal d'entrée x(t);

un troisième comparateur (102) destiné à comparer ladite valeur absolue de crête à la valeur absolue présente desdits mots binaires et à incrémenter ladite valeur absolue de crête à chaque fois qui ladite valeur présente dépasse ladite valeur absolue de crête et

un circuit adaptatif (104, 106) destiné à déterminer la différence entre ladite valeur absolue de crête et la valeur présente desdits mots binaires et à faire changer l'état dudit bit de signe lorsque la différence dépasse un niveau de référence.

3. Convertisseur analogique-numérique à interpolation selon la revendication 2, caractérisé en ce que ledit circuit adaptatif comprend un circuit logique soustracteur (104) destiné à soustraire la valeur absolue de ladite valeur présente de ladite valeur absolue de crête pour produire un signal de différence, et un comparateur (106) destiné à comparer ledit signal de différence à un signal de référence et à produire un signal de changement de bit de signe destiné à être appliqué à l'entrée dudit circuit logique afin de produire un changement d'état dudit bit de signe et d'améliorer ainsi la réponse en fréquence du système.

4. Convertisseur analogique-numérique à interpolation selon les revendications 2 ou 3, caractérisé en ce qu'il comprend en outre un circuit (110) destiné à déterminer la signe du signal d'entrée et à comparer ledit signe au signe de chaque signal quantifié q(t) pendant une période d'échantillonnage prédéterminée et à changer la valeur dudit signal de référence de façon que le nombre de niveaux de signal actifs dudit registre à décalage soit changé de manière correspondante.

5. Convertisseur analogique-numérique à interpolation selon les revendications 1, 2 ou 3, caractérisé en ce que ledit circuit de traitement de signal numérique comprend un filtre (figure 12) qui comporte des zéros de transmission multiples à toutes les fréquences de repliement du signal.

6. Convertisseur analogique-numérique à interpolation selon la revendication 5, caractérisé en ce que ledit filtre comprend un élément d'enregistrement de coefficients (122), un processeur arithmétique (120) destiné à multiplier lesdits mots binaires par des coefficients prédéterminés enregistrés dans ledit élément d'enregistrement et des moyens additionneur et accumulateur (126) destinés à sommer et enregistrer les produits de ladite opération de multiplication.

7. Convertisseur analogique-numérique à interpolation selon la revendication 5, caractérisé en ce qu'il comprend en outre

un circuit de zéro automatique (94) destiné à produire un signal de compensation de décalage à appliquer à l'entrée dudit intégrateur pour compenser les décalages présents dans le système.

8. Convertisseur analogique-numérique à interpolation selon la revendication 7, caractérisé en ce que ledit circuit de zéro automatique (94) comprend des compteurs destinés à intégrer le bit de signe d'un signal binaire produit par ledit circuit de traitement de signal, et un convertisseur numérique-analogique (95) destiné à convertir le signal de sortie desdits compteurs sous une forme analogique pour produire ledit signal de compensation de décalage.

*Fig. 1*

**Fig. 2**

$$V_{n+1} = \frac{2}{3}(2^{n+1}) - 1$$

$$V_{1n} = Y_n = \frac{2}{3}(2^n) - 1$$

$$V_{n-1} = \frac{2}{3}(2^{n-1}) - 1$$

3 LEVEL INTERPOLATION AT $F_S$

**Fig. 3a**

$$V_n = 2^{n+1}$$

$$V_{IN} = \frac{2}{3}(2^n) - 1$$

$$V_n = 2^n$$

2 LEVEL INTERPOLATION AT $F_S/2$

**Fig. 3b**

2

Fig. 4a

Fig. 4b

Fig. 8

Fig. 5

Fig. 6

**Fig. 7**

**Fig. 10**

Fig. 9

Fig. 11

$$Y_o = \frac{1}{256} \sum_{i=0}^{i=22} a_i x_i$$

**Fig. 12**

**Fig. 13**